# FASCICULE DE BREVET EUROPEEN

(11) **EP 1 271 645 B1**
(45) Date de publication et mention de la délivrance du brevet: **04.07.2018**
(21) Numéro de dépôt: 02291288.5
(22) Date de dépôt: 28.05.2002
(51) Int. Cl.: H01L 23/40, H05K 7/10

(54) **Dispositif et procédé de fixation de circuits intégrés sur une carte à circuit imprimé**
Verfahren und Vorrichtung zur Befestigung von integrierten Schaltungen auf einer Leiterplatte
Method and device for fastening IC packages on a printed circuit board

(30) Priorité: 19.06.2001 FR 0108008
(43) Date de publication de la demande: 02.01.2003
(73) Titulaire: Bull SAS, 78340 Les Clayes-sous-Bois (FR)
(72) Inventeur: Petit, Claude, 91140 Villebon sur Yvette (FR); Fromont, Thierry, 91300 Massy (FR)
(74) Mandataire: Bonnet, Michel

(56) Documents cités:
- EP-A- 0 706 313
- US-A- 4 159 483
- US-A- 5 730 210
- US-A- 5 793 618
- US-A- 5 978 223
- US-A- 6 154 365

## Description

### Domaine technique

L'invention se rapporte à un dispositif de fixation d'un composant électrique à une carte de circuit imprimé. L'invention s'applique tout particulièrement à des circuits intégrés dont le contact avec les plages de connexion de la carte de circuit imprimé s'effectue par pression. Un circuit intégré pourvu d'une pluralité de bornes de contact constituant une matrice de contacts plats LGA (Land Grid Array) est tout à fait adapté à la mise en oeuvre de l'invention et de ce fait servira d'exemple pour l'illustration de l'invention.

### Etat de la technique

Traditionnellement, un circuit intégré est mis dans un boîtier comprenant des bornes de contact. Dans la suite de la description, on utilisera l'expression "circuit intégré LGA" pour désigner aussi bien un circuit intégré LGA qu'un circuit placé dans un boîtier.

Traditionnellement, le circuit intégré LGA comporte deux faces, l'une active et l'autre inactive. La face active comporte les bornes de contact.

Généralement, la connexion du circuit intégré LGA sur la carte de circuit imprimé nécessite d'empiler un certain nombre d'éléments. On place un interposeur comprenant des contacts électriques souples entre le circuit intégré LGA et la carte de circuit imprimé pour les relier électriquement. Ce système nécessite d'être mis en pression pour assurer un bon contact électrique. Ceci est réalisé par une plaque de mise en pression posée sur la face non active du circuit intégré LGA. Le dispositif est complété par un radiateur éventuel servant à assurer la dissipation thermique. Une variante consiste à fondre la plaque de mise en pression et le radiateur en une même pièce. Généralement, un joint thermique s'intercale entre le circuit intégré LGA et le radiateur pour un meilleur transfert de l'énergie en direction du radiateur.

La pression est appliquée par exemple par des ressorts appuyant sur la plaque ou la plaque-radiateur. Ces ressorts sont généralement guidés par des colonnettes liées au circuit imprimé soit par inserts ou par des écrous pratiqués dans la carte de circuit imprimé.

Un premier problème soulevé par cette technique est que les systèmes actuels ne permettent pas de monter des circuits intégrés, en particulier des circuits intégrés dont les contacts électriques sur la carte de circuit imprimé s'effectue par pression, sur deux côtés opposés en regard de la carte de circuit imprimé. Un autre problème est que les inserts ou écrous occupent une surface non négligeable sur la carte de circuit imprimé. Ceci constitue un frein a la densité des composants. La surface occupée par ces écrous sur la carte de circuit imprimé est intolérable dans un monde où la miniaturisation est une pièce maîtresse.

En outre, les inserts ou les écrous déforment localement la carte. Les contraintes réalisées peuvent entraîner la rupture de pistes situées à proximité des inserts ou des écrous. Il faut donc limiter le passage de piste, et la densité de routage est réduite en conséquence.

Par ailleurs, la demande de brevet européen publiée sous le numéro EP 0 706 313 A1 décrit que la fixation d'un substrat sur un connecteur 1 et que la fixation du connecteur 1 sur une carte de circuit imprimé 11 sont réalisées au moyen d'une plaque de montage 19 avec quatre écrous de montage 20 et d'un cadre de montage 21 qui est posé sur les écrous de montage 20 avec des ouvertures 22.

Le brevet publié sous le numéro US 5,793,618 décrit un dispositif pour fixer deux modules à des côtés opposés d'une carte de circuit imprimé. Le dispositif comporte une paire d'éléments de serrage pour serrer les modules contre la carte de circuit imprimé. L'assemblage de serrage est monté sur quatre tiges d'alignement, ces tiges passant au travers d'ouvertures traversant la carte de circuit imprimé.

Le brevet publié sous le numéro US 5,978,223 décrit un assemblage comportant une carte de circuit imprimé, des modules montés sur le dessous de la carte et des modules montés sur le dessus de la carte. Le brevet décrit en outre que les modules sont montés par fusion ou refusion des broches de raccordement des modules. Le brevet décrit en outre que des échangeurs de chaleur sont mécaniquement maintenus en place par des assemblages à tiges et ressorts. Les tiges s'étendent au travers d'ouvertures traversant la carte de circuit imprimé et présentent à leurs extrémités des vis de compression des ressorts.

### L'invention

Un premier but de l'invention est d'autoriser le montage de circuits intégrés LGA des deux côtés de la carte de circuit imprimé.

Un deuxième but est l'utilisation de moyens de fixation dont la base ne déforme pas la carte de circuit imprimé et occupe le moins de surface possible permettant de ce fait une densité de routage plus importante.

Un troisième but de l'invention est de préserver une grande facilité de montage des circuits intégrés sur la carte de circuit imprimé.

Un quatrième but est de réduire au maximum le coût en argent et en temps d'une telle mise en oeuvre.

A cet effet, l'invention a pour objet un dispositif selon la revendication 1.

Des caractéristiques optionnelles du dispositif sont présentées dans les revendications 2 à 6. L'invention a aussi pour objet un procédé selon la revendication 7. L'invention sera mieux comprise à la lecture de la description qui suit, donnée à titre d'exemple et faite en référence aux dessins annexés.

### Dans les dessins:

La figure 1 est une vue éclatée des différents éléments à empiler pour la connexion de circuits intégrés sur deux faces opposées en regard de la carte de circuit imprimé.
La figure 2 est une vue en perspective d'une partie d'un exemple d'illustration d'un élément des moyens de fixation.
La figure 3 est une vue d'un exemple de réalisation d'un moyen assurant le bon empilage des différents éléments susmentionnés.
La figure 4 est une vue de dessus de l'assemblage réalisé conformément à un exemple de réalisation de l'invention.
La figure 5 est une vue d'un outillage permettant de monter ou de démonter un circuit intégré LGA de la carte de circuit imprimé.
La figure 6 est une vue de l'assemblage réalisé mettant en évidence la fixation des circuits intégrés sur deux faces opposées de la carte de circuit imprimé.

Pour simplifier la description, dans les dessins les mêmes éléments portent les mêmes références.

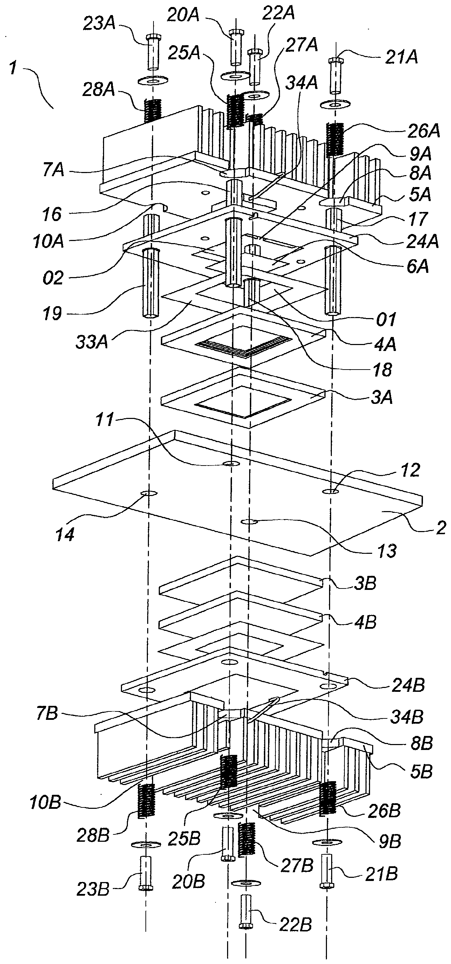

La figure 1 est une vue éclatée en perspective partielle illustrant un assemblage 1 mettant en évidence les éléments à empiler sur une carte de circuit imprimé 2. La carte de circuit imprimé comprend sur ses deux faces des plages de connexion (non représentées sur les figures).

Dans l'exemple illustré, un assemblage A sur une face de la carte de circuit imprimé 2 consiste à empiler plusieurs éléments. Les éléments à empiler sont, notamment:
- un interposeur 3A comprenant des contacts électriques souples sur ses deux faces s'intercale entre le circuit intégré LGA et la carte de circuit imprimé pour les relier électriquement.
- le circuit intégré LGA 4A comprenant une surface active, c'est-à-dire une surface pourvue de bornes de contacts d'entrée-sortie. Cette face active est en contact avec l'interposeur 3A.
- un radiateur 5A propre à dissiper l'énergie produite par le circuit intégré LGA 4A est posé sur la surface non active du circuit intégré LGA.
- un joint thermique 6A qui s'intercale entre la surface non active du circuit intégré LGA 4A et le radiateur 5A pour constituer une liaison thermique entre ces deux éléments.
Naturellement, cet assemblage ne constitue qu'un mode de réalisation.
Dans notre exemple de réalisation, le radiateur 5A est pourvu d'encoches 7A-10A, pouvant recevoir librement des colonnettes 16-19 propres à prendre en sandwich l'ensemble des éléments mentionnés précédemment afin d'établir la connexion des bornes de contact du circuit intégré LGA 4A avec les contacts électriques de la carte de circuit imprimé 2A.

Le problème, tel que mentionné précédemment, est qu'il n'existe pas de moyens permettant de fixer des circuits intégrés sur deux faces opposées en regard de la carte de circuit imprimé.
Une solution consiste par exemple à utiliser des moyens de fixation qui s'étendent au travers de trous 11-14 pratiqués dans la carte de circuit imprimé 2 pour fixer des circuits 4A et 4B intégrés situés sur des faces opposées en regard de la carte 2.
Le montage des différents éléments à empiler est symétrique par rapport à la carte de circuit imprimé. L'assemblage B du deuxième circuit intégré 4B consiste à empiler les mêmes éléments que précédemment.
Dans la suite de la description, chaque élément de même type du deuxième assemblage sera référencé avec le même numéro que le même élément situé symétriquement par rapport a la carte de circuit imprimé dans le premier assemblage décrit ci-dessus. Une lettre A ou B permettra de distinguer l'assemblage dans lequel l'élément est empilé.

Dans notre exemple de réalisation, une partie des moyens de fixation sont des colonnettes 16-19. Les colonnettes s'étendent au travers des trous 11-14 de la carte à circuit imprimé 2, de chaque côté de la carte de circuit imprimé. Chaque colonnette est partagée entre deux circuits intégrés 4A et 4B disposés sur deux côtés opposés en regard de la carte de circuit imprimé 2 et a la particularité de ne pas être fixée à la carte de circuit imprimé.

Dans l'exemple illustré, les colonnettes 16-19 sont au nombre de quatre. Naturellement, ce nombre peut être quelconque.

Chaque colonnette comprend une partie taraudée à ses extrémités propre à recevoir une vis respective 20A-23A et 20B-23B. Naturellement, l'utilisation de telles colonnettes ne constitue qu'un mode de réalisation préféré de l'invention, d'autres moyens de fixation n'utilisant pas de vis pouvant tout à fait être envisageable.

Dans l'exemple de réalisation préféré de l'invention, pour éviter tout mouvement de rotation des colonnettes lors du montage ou démontage, la solution consiste à utiliser conjointement les colonnettes 16- 19 et une plaque 24A et 24B de chaque côté de la carte de circuit imprimé. Cette plaque 24A et 24B est dotée de trous pour l'insertion des colonnettes. La fonction des trous est, notamment, d'empêcher tout mouvement de rotation des colonnettes 7A-7D.

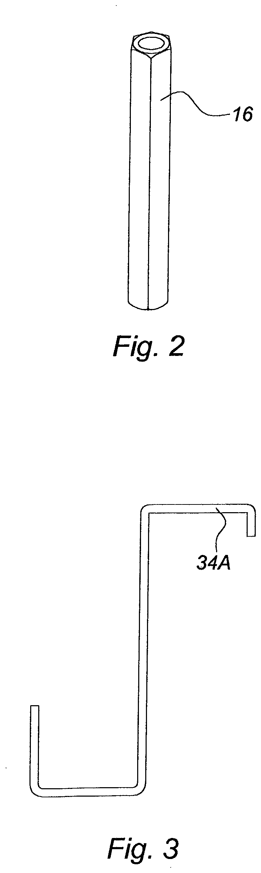

Dans notre exemple de réalisation, la section des trous et des colonnettes est hexagonale. La figure 2 est une vue en perspective d'une colonnette mettant en évidence la section hexagonale de celle-ci. Naturellement, cet exemple n'est en aucun cas limitatif et toute autre section empêchant un mouvement de rotation des colonnettes peut être envisagée.

De préférence, un isolant électrique 33A et 33B s'intercale entre chaque plaque 24A et 24B et circuit intégré respectif 4A et 4B. L'isolant 33A et la plaque 24A comporte des ouvertures respectives 01 et 02 propres à permettre un contact entre le circuit 4A et 4B et le radiateur respectif 5A et 5B. Un joint thermique 6A recouvre le circuit intégré 4A proprement dit pour une meilleure dissipation de la chaleur sur la partie du radiateur 5A

Dans notre exemple de réalisation, chaque plaque 24A et 24B est non seulement un moyen permettant de bloquer les colonnettes en rotation, mais assure également une pression uniforme sur l'assemblage lors du montage. Chaque plaque 24A et 24B se situe dans l'empilage entre le radiateur 5A et 5B et le circuit intégré 4A et 4B, respectivement. Il est considéré comme utile à la compréhension de l'invention que la plaque peut être remplacée par tout autre moyen assurant à la fois un blocage en rotation des colonnettes et une pression uniforme lors du montage ou du démontage. Par exemple, une autre variante utile à la compréhension de l'invention consiste à doter la base de chaque radiateur 5A et 5B de trous avec la même fonction qu'une plaque. Les trous assurent à la fois un blocage en rotation des colonnettes et la base du radiateur assure une pression uniforme lors du montage ou du démontage.

La force de pression à exercer sur chaque assemblage A et B doit être calibrée et réalisée avec beaucoup de précaution. Une solution consiste à équiper chaque colonnette de ressorts (25A,26A,27A,28A) pour l'assemblage A et de ressorts (25B, 26B, 27B, 28B) pour l'assemblage B pour appliquer une force F nécessaire pour établir le contact électrique entre chaque circuit intégré 4A et 4B et la carte de circuit imprimé 2. Dans l'exemple illustré, les ressorts (25A,26A,27A,28A) de l'assemblage A et les ressorts (25B, 26B, 27B, 28B) de l'assemblage B prennent appui sur la plaque respective 24A et 24B. De préférence, les colonnettes 16-19 sont équipées de ressorts de même coefficient de raideur K pour exercer une pression uniforme. La tête de chaque vis 20A-23A et 20B-23B, lors du vissage, comprime, éventuellement par l'intermédiaire d'une rondelle, le ressort respectif pour entraîner dans son mouvement le circuit intégré respectif 4A,4B pour sa connexion sur la carte de circuit imprimé 2. Le dévissage de chaque vis 20A-23A et 20B-23B a pour effet aussi de décomprimer le ressort respectif (25A,26A,27A,28A) et (25B, 26B, 27B, 28B) pour déconnecter le circuit intégré respectif 4A et 4B de la carte de circuit imprimé 2.

Dans notre exemple de réalisation, la longueur choisie de la vis est telle qu'une fois le ressort décompressé, la vis respective resté toujours engagée dans le taraudage de la colonnette respective.

Les ressorts (25A,26A,27A,28A) et (25B, 26B, 27B, 28B) ne prennent pas appui sur les radiateurs car la pression appliquée nécessaire pour assurer un bon contact électrique des contacts est différente de la pression nécessaire à un bon contact thermique entre un circuit intégré 4A et 4B et le radiateur respectif 5A et 5B. Une solution consiste à lier ces deux composants (radiateur et plaque) par l'intermédiaire d'au moins un clip de torsion respectif 34A et 34B. Un clip de torsion est représenté à la figure 3. Un clip de torsion a pour fonction d'appliquer une force indépendante de la force de pression F à appliquer pour les contacts électriques. Ceci constitue un moyen pour rendre indépendant différentes forces de pression à appliquer. Chaque clip de torsion 34A et 34B prend appui par ses deux extrémités sur une surface d'appui du radiateur respectif 5A et 5B et par son corps sur une surface d'appui opposée de la plaque.

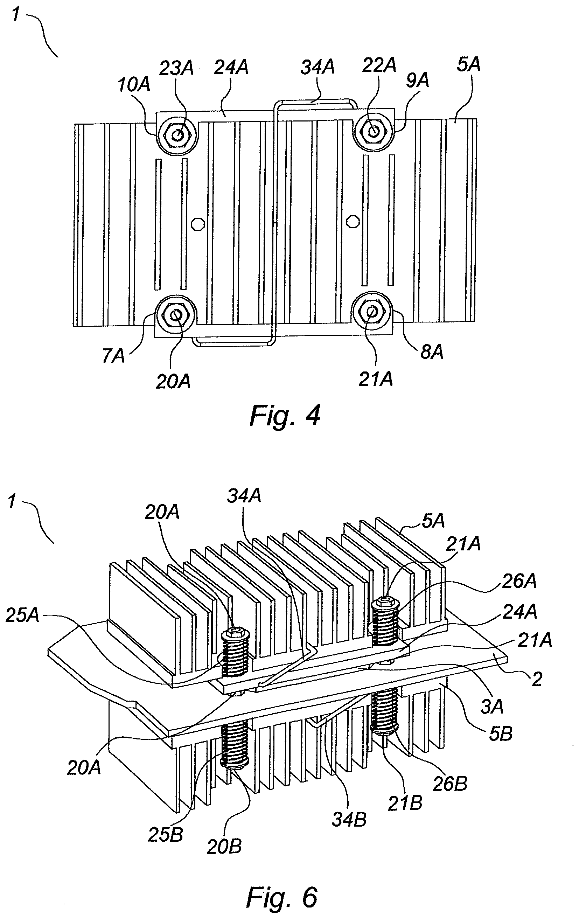

La figure 4 représente une vue de dessus de l'assemblage A. Sur cette figure, on peut voir le radiateur 5A, les encoches 7A-9A pratiquées dans le radiateur plus larges que les colonnettes et les ressorts, les têtes des vis 20A-23A, la plaque 24A et le clip de torsion 34A prenant en sandwich le radiateur 5A et la plaque 24A.

Par précaution, les circuits intégrés 4A et 4B sont montés l'un après l'autre. Le montage du premier circuit intégré 4A est réalisé par l'intermédiaire d'une cale qui permet de remplacer le deuxième assemblage qui n'est pas encore monté. Cette cale est représentative de l'épaisseur d'un assemblage.
Après avoir monté le premier circuit intégré 4A, on retire la cale. Les colonnettes pouvant se déplacer perpendiculairement à la carte de circuit imprimé, le montage du deuxième circuit intégré 4B sur l'autre face de la carte de circuit imprimé est réalisé par l'intermédiaire d'un outillage 35. La figure 5 est une vue d'un exemple de réalisation d'un tel outillage.
Dans notre exemple de réalisation, cet outillage 35 est un boîtier parallélépipédique dont une de ses deux faces opposées est ouverte. La face pleine est constituée d'une plaque portant quatre arbres 29-30, chaque arbre étant entouré d'un ressort respectif, dont deux sont visibles sur la figure 5, à savoir les ressorts 31-32, de coefficient de raideur K' inférieur ou égal au coefficient de raideur K des ressorts (25A,26A,27A,28A) et (25B, 26B, 27B, 28B). Chaque arbre guide le ressort respectif dans son mouvement et a une longueur inférieure à celle d'un ressort 31-32.
Lors du montage, ou du démontage suivi d'un remontage, de ce deuxième circuit intégré 4B, on place le boîtier, par exemple sur un support horizontal, les arbres 29-30 étant dirigés vers le haut. On place la carte de circuit imprimé 2 sur ce boîtier de façon à introduire l'assemblage A réalisé dans le boîtier, les axes des colonnettes 16-19 coïncidant avec les axes des arbres 29-30 du boîtier 35.
De préférence, le boîtier 35 est fixé à la carte de circuit imprimé pour une meilleure manipulation. Le mode de fixation est arbitraire.
Les ressorts 31-32 du boîtier 35 entrent en contact avec les têtes des vis (20A-23A) de l'assemblage A. Dans le boîtier 35, chaque ressort 31-32 exerce une force compensant le poids de cet assemblage, empêchant tout mouvement de translation des colonnettes 16-19 perpendiculairement à la carte de circuit imprimé 2.
L'empilement est symétrique de chaque côté de la carte de circuit imprimé. Lors du montage de l'assemblage B, les colonnettes étant bloquées en rotation et en translation, le vissage ou le dévissage s'effectue sans problème.

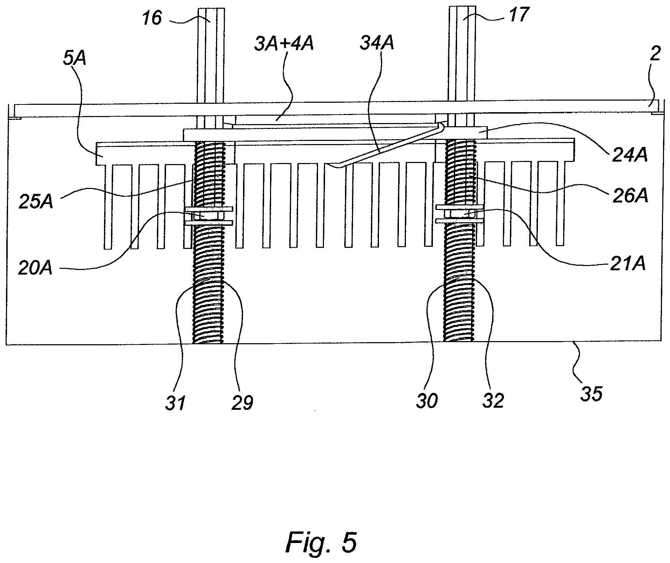

Considérons que l'assemblage A soit dans la le boîtier dans la même position que décrite précédemment et que l'assemblage B soit réalisé totalement. Si, on souhaite à nouveau démonter l'assemblage B, on retire les vis 20B-23B. Lors du retrait des vis de l'assemblage B, bien que les ressorts de l'assemblage B se décompressent, le boîtier quant à lui maintient une pression suffisante sur les ressorts de l'assemblage A assurant un bon contact électrique du circuit intégré 4A sur la carte de circuit imprimé 2.
Les ressorts du boîtier permettent de décompresser les ressorts (25A,26A,27A,28A) et (25B, 26B, 27B, 28B) des deux côtés de la carte de circuit imprimé 2. L'opération de dévissage, par exemple des vis 20B-23B, sur un côté de la carte de circuit imprimé décomprime les ressorts respectifs 25B-28B de l'assemblage B ainsi que les ressorts 25A-28A de l'assemblage A. Les ressorts du boîtier assure donc l'égalité des pressions des 2 cotés du circuit imprimé pendant une période de temps. De préférence, le coefficient de raideur des ressorts du boîtier sont choisis de telle façon que, lorsque les forces s'annulent et qu'il y a équilibre, le contact électrique du circuit intégré 4A soit suffisant.
Le résultat des opérations précédentes aboutit à l'assemblage visible sur la figure 6 représentant l'assemblage réalisé.
Le procédé de montage d'un circuit intégré 4A ou 4B, à partir d'une carte de circuit imprimé 2 vierge de composants, peut s'effectuer en plusieurs étapes. A noter que le sens d'exécution des étapes est tout à fait arbitraire. Le sens d'exécution choisi est celui qui paraît le plus approprié et le plus aisé pour un homme du métier.

Considérons que l'on veuille monter le circuit intégré 4A et ensuite le circuit intégré 4B.

### Etape E1

Une étape préliminaire consiste à insérer, à travers les trous 11-14 prévus à cet effet dans le circuit imprimé 2, et du coté opposé de la carte de circuit imprimé sur laquelle on souhaite monter le circuit intégré 4A, une cale centrale. Cette cale est équivalente en dimension à une plaque 24A ou 24B mais avec une épaisseur représentative de l'épaisseur d'un assemblage. On place les ressorts autour des colonnettes et on presse la cale contre le carte de circuit imprimé 2 par l'intermédiaire des vis 20B-23B.

### Etape E2

Une deuxième étape consiste à placer l'interposeur 3A sur la carte de circuit imprimé 2 de telle façon que les contacts électriques coïncident.

### Etape E3

Une troisième étape consiste à poser le circuit intégré 4A sur l'interposeur 3A de telle façon que les broches du circuit 4A coïncident avec les contacts électriques de l'interposeur 3A.

### Etape E4

De préférence, préalablement à l'application d'une pression par l'intermédiaire de la plaque 24A, et de façon à assurer un montage plus aisé, on réalise les deux sous-étapes suivantes:
- On pose l'isolant électrique 33A sur le circuit intégré 4A de façon à isoler électriquement la plaque 24A du circuit intégré 4A.
- On pose le joint thermique 6A
Le sens d'exécution de ces 2 sous-étapes est indifférent.

### Etape E5

Une cinquième étape consiste à poser la plaque 24A sur les éléments empilés lors des étapes E2 à E4. La plaque 24A est guidée par l'intermédiaire de ses trous par les colonnettes 16-19.

### Etape E6

Une sixième étape consiste à insérer un ressort 25A-26A sur chaque colonnette 16-19.

### Etape E7

Une septième étape consiste à poser le radiateur 5A en laissant passer les colonnettes et ressorts dans les encoches 7A-10A du radiateur prévues à cet effet.

### Etape E8

Lorsque l'empilage est réalisé, une huitième étape consiste à visser les vis 20A-23A sur les colonnettes respectives 16-19 pour réaliser une pression de façon à ce que les différents contacts électriques s'établissent.

A ce stade, le circuit intégré 4A est monté sur la carte de circuit imprimé 2

### Etape E9

Ensuite, on place le montage A réalisé dans le boîtier 35 de telle façon que les ressorts 31-32 du boîtier de maintien entrent en contact avec les têtes des vis de l'assemblage A.

### Etape E10

L'étape suivante consiste à retirer la cale insérée à l'étape E1. Lors du retrait de la cale, les ressorts du boîtier 35 exercent une force compensant le poids de l'assemblage A dans le boîtier 35 et empêche ainsi aux colonnettes et à l'assemblage A de se déplacer perpendiculairement au plan de la carte de circuit imprimé.
Il reste alors à monter le deuxième circuit intégré 4B sur la face de la carte de circuit imprimé sur laquelle s'étendent les colonnettes et à réaliser de nouveau le montage décrit conformément aux étapes E2 à E8.

Considérons maintenant que les deux circuit intégré 4A et 4B sont fixés à la carte de circuit imprimé 2 et que l'on veuille démonter le circuit intégré 4B.
Pour une intervention de démontage, suivi d'un remontage d'un circuit intégré, sur une carte de circuit imprimé déjà équipée de circuits intégrés LGA des 2 cotés, on effectue les opérations suivantes :

### Etape F1

On place l'assemblage A dans l'outillage de telle façon que les ressorts 31,32 de celui-ci entrent en contact avec les têtes des vis de l'assemblage A.

### Etape F2

On dévisse ensuite les vis 20B-23B de façon à libérer la pression des ressorts respectifs 25B-28B. A la fin de l'opération les ressorts 31,32 du boîtier exercent une force compensant le poids de l'assemblage A dans le boîtier 35 et empêche ainsi aux colonnettes et à l'assemblage A de se déplacer perpendiculairement au plan de la carte de circuit imprimé.

### Etape F3:

On retire successivement tous les élément empilés de l'assemblage B (radiateur, plaque, interposeur, etc.).

### Etape F4:

L'étape suivante consiste à remonter le deuxième circuit intégré 4B sur la face de la carte de circuit imprimé sur laquelle s'étendent les colonnettes et à réaliser de nouveau le montage décrit conformément aux étapes E2 à E8.

D'une manière générale, l'invention se rapporte à un dispositif tel que défini au revendication 1. On a vu que les moyens de fixations exercent des pressions égales de part et d'autre de la carte de circuit imprimé (2).
Dans notre exemple de réalisation, les moyens de fixation sont des colonnettes 16-19, chaque colonnette comprenant en ses deux extrémités une partie
taraudée propre à recevoir une vis pour les composants électriques 4A,4B sur des faces opposées de la carte de circuit imprimé. On a vu que l'utilisation de colonnettes ne constitue qu'un mode de réalisation préféré de l'invention, d'autres moyens de fixation n'utilisant pas de vis pouvant tout à fait être envisageable.
La fixation étant symétrique, et la fixation s'effectuant par l'intermédiaire de vis, il est nécessaire d'empêcher tout mouvement de rotation des colonnettes lors du vissage ou du dévissage. Une solution possible consiste à utiliser une plaque 8 de chaque côté de la carte de circuit imprimé, ladite plaque 8 comprenant des encoches traversées par les colonnettes, le profil des trous et des colonnettes empêchant tout mouvement de rotation des colonnettes pour le montage ou le démontage.
On a vu aussi que la connexion électrique doit être réalisée avec beaucoup de précision. Dans notre exemple de réalisation, on a choisi d'utiliser, de chaque côté de la carte de circuit imprimé 2, des ressorts 25A-28A et 25B-28B s'intercalent entre la tête de chaque vis respective 20A-23A et 20B-23B et la plaque respective 24A,24B, l'une des extrémités du ressort prenant appui sur la plaque respective 24A,24B. De préférence, de chaque côté de la carte de circuit imprimé, chaque colonnette 16-19 est équipée d'un ressort de même coefficient de raideur pour exercer une pression uniforme propre à établir le contact électrique entre chaque composant électrique 4A,4B et la carte de circuit imprimée 2.

On a vu aussi que différentes forces de pression doivent être appliquées à certains éléments d'un assemblage. Dans notre exemple, de chaque côté de la carte de circuit imprimé 2, un radiateur 5A et 5B est monté sur la plaque respective 24A et 24B, et en ce qu'un clip de torsion 27A,27B relie le radiateur 5A,5B et la plaque 24A,24B respectives pour exercer sur cet ensemble une force de pression indépendante de la force de pression produite par les ressorts.

On a vu aussi que la présente invention est tout à fait adapté à des circuits intégrés dont le contact électrique sur la carte de circuit imprimé s'effectue par pression.

Le montage ou le démontage des assemblages nécessite l'utilisation d'un outillage particulier. Cet Outillage 35 comprend des moyens pour exercer une pression sur un premier composant électrique 4A fixé sur une première face de la carte de circuit imprimé, de façon à monter ou démonter un deuxième composant électrique 4B sur la face en regard de la carte de circuit imprimé 2. Dans notre exemple de réalisation, on a les moyens pour exercer une pression sont des ressorts (31,32) dont l'axe coïncide avec l'axe des colonnettes (16-19). On s'aperçoit donc que la présente invention offre de nombreux avantages. Le dispositif de l'invention autorise le montage de circuits intégrés sur deux côtés opposés en regard de la carte de circuit imprimé tout en assurant un montage et démontage indépendant de chacun des deux circuits intégrés grâce à l'outillage 35. Le passage des colonnettes au travers de la carte de circuit imprimé évite d'utiliser des écrous ou des inserts. Ainsi, on minimise ainsi les zones interdites au routage dans la zone proche du trou. De plus, on voit bien que l'utilisation conjointe des colonnettes et d'une plaque permet d'appliquer une pression nécessaire à un bon contact électrique symétrique des deux côtés de la carte de circuit imprimé lors des opérations de montage et de démontage.

## Revendications

1. Dispositif (1) comportant :
- une carte de circuit imprimé (2) comprenant des plages de connexion sur ses deux faces opposées et traversée par des ouvertures (11, 12, 13,14),
- deux assemblages comportant chacun :
• un circuit intégré (4A, 4B) présentant une face électriquement active et une face électriquement non active,
• un radiateur (5A, 5B) en contact thermique avec la face électriquement non active du circuit intégré (4A, 4B), et
• une plaque (24A, 24B) dotée de trous, placée entre le circuit intégré (4A, 4B) et le radiateur (5A, 5B),
- des moyens de fixation (16, 17, 18, 19) à ressorts (25A, 25B, 26A, 26B, 27A, 27B, 28A, 28B), reçus dans les ouvertures (11, 12, 13, 14) de la carte de circuit imprimé (2) et dans les trous de chaque plaque (24A, 24B), qui s'étendent au travers de la carte de circuit imprimé (2) et de chaque plaque (24A, 24B), fixant les deux assemblages respectivement sur les deux faces opposées de la carte de circuit imprimé (2) pour établir un contact électrique entre la face électriquement active du circuit intégré (4A, 4B) de chaque assemblage et la face de la carte de circuit imprimé (2) sur laquelle cet assemblage est fixé,
**caractérisé en ce que**
- les ressorts (25A, 25B, 26A, 26B, 27A, 27B, 28A, 28B) des moyens de fixation (16, 17, 18, 19) prennent appui contre les plaques (24A, 24B) en exerçant une force de pression pour assurer ledit contact électrique, et
- chaque assemblage comprend en outre un clip de torsion (34A, 34B) reliant son radiateur (5A, 5B) et sa plaque (24A, 24B) en exerçant sur cet ensemble radiateur-plaque (5A-24A, 5B-24B) une force de pression indépendante de la force de pression exercée par les ressorts.

2. Dispositif selon la revendication 1, **caractérisé en ce que** les ressorts (25A, 25B, 26A, 26B, 27A, 27B, 28A, 28B) des moyens de fixation (16, 17, 18, 19) exercent des pressions égales de part et d'autre de la carte de circuit imprimé (2).

3. Dispositif selon la revendication 1 ou 2, **caractérisé en ce que** les moyens de fixation (16, 17, 18, 19) sont des colonnettes, chaque colonnette comprenant en ses deux extrémités une partie taraudée recevant une vis pour fixer les circuits intégrés (4A, 4B).

4. Dispositif selon la revendication 3, **caractérisé en ce que** les profils des trous des plaques (24A, 24B) et des colonnettes (16, 17, 18, 19) empêchent tout mouvement de rotation des colonnettes (16, 17, 18, 19) pour le montage ou le démontage.

5. Dispositif selon la revendication 3 ou 4, **caractérisé en ce que** les ressorts (25A, 25B, 26A, 26B, 27A, 27B, 28A, 28B) sont intercalés entre la tête de chaque vis et la plaque respective (24A, 24B), l'une des extrémités de chaque ressort prenant appui sur la plaque respective (24A, 24B).

6. Dispositif selon l'une des revendications 3 à 5, **caractérisé en ce que**, de chaque côté de la carte de circuit imprimé (2), chaque colonnette (16, 17, 18, 19) est équipée d'un ressort de même coefficient de raideur pour exercer une pression uniforme propre à établir le contact électrique entre chaque circuit intégré (4A, 4B) et la carte de circuit imprimée (2).

7. Procédé pour monter un dispositif (1) selon l'une quelconque des revendications 1 à 6, **caractérisé en ce qu'**il comporte : l'utilisation d'un outillage qui comprend des moyens pour exercer une pression sur un premier circuit intégré (4A) fixé sur une première face de la carte de circuit imprimé, de façon à monter un deuxième circuit intégré (4B) sur la face en regard de la carte de circuit imprimé (2).

## Patentansprüche

1. Vorrichtung (1), aufweisend:
- eine Leiterplatte (2), umfassend Anschlussbereiche auf ihren zwei gegenüberliegenden Flächen, die von Öffnungen (11, 12, 13, 14) durchquert wird,
- zwei Anordnungen, aufweisend jeweils:
• ein integrierter Schaltkreis (4A, 4B), aufweisend eine elektrisch aktive Fläche und eine elektrisch nicht aktive Fläche,
• einen Radiator (5A, 5B) in thermischem Kontakt mit der elektrisch nicht aktiven Fläche des integrierten Schaltkreises (4A, 4B), und
• eine mit Löchern ausgestattete Platte (24A, 24B), die zwischen dem integrierten Schaltkreis (4A, 4B) und dem Radiator (5A, 5B) platziert ist,
- Befestigungsmittel (16, 17, 18, 19) mit Federn (25A, 25B, 26A, 26B, 27A, 27B, 28A, 28B), aufgenommen in den Öffnungen (11, 12, 13, 14) der Leiterplatte (2) und in den Löchern jeder Platte (24A, 24B), die sich durch die Leiterplatte (2) und jede Platte (24A, 25B) erstrecken, wobei die zwei Anordnungen jeweils auf den zwei gegenüberliegenden Flächen der Leiterplatte (2) befestigt sind, um einen elektrischen Kontakt zwischen der elektrisch aktiven Fläche des integrierten Schaltkreises (4A, 4B) jeder Anordnung und der Fläche der Leiterplatte (2) herzustellen, auf der diese Anordnung befestigt ist,
**dadurch gekennzeichnet, dass**
- sich die Federn (25A, 25B, 26A, 26B, 27A, 27B, 28A, 28B) der Befestigungsmittel (16, 17, 18, 19) auf den Platten (24A, 24B) abstützen, indem sie eine Druckkraft ausüben, um den elektrischen Kontakt zu sichern, und
- jede Anordnung ferner einen Torsionsclip (34A, 34B) umfasst, der ihren Radiator (5A, 5B) und ihre Platte (24A, 24B) verbindet, indem auf diese Einheit Radiator-Platte (5A-24A, 5B-24B) eine von der von den Federn ausgeübten Druckkraft unabhängige Druckkraft ausgeübt wird.

2. Vorrichtung nach Anspruch 1, **dadurch gekennzeichnet, dass** die Federn (25A, 25B, 26A, 26B, 27A, 27B, 28A, 28B) der Befestigungsmittel (16, 17, 18, 19) gleiche Drücke beiderseits der Leiterplatte (2) ausüben.

3. Vorrichtung nach Anspruch 1 oder 2, **dadurch gekennzeichnet, dass** die Befestigungsmittel (16, 17, 18, 19) Säulen sind, wobei jede Säule an ihren beiden Enden einen Gewindeteil umfasst, der eine Schraube aufnimmt, um die integrierten Schaltkreise (4A, 4B) zu befestigen.

4. Vorrichtung nach Anspruch 3, **dadurch gekennzeichnet, dass** die Profile der Löcher der Platten (24A, 24B) und der Säulen (16, 17, 18, 19) jedwede Rotationsbewegung der Säulen (16, 17, 18, 19) für die Montage oder die Demontage verhindern.

5. Vorrichtung nach Anspruch 3 oder 4, **dadurch gekennzeichnet, dass** sich die Federn (25A, 25B, 26A, 26B, 27A, 27B, 28A, 28B) zwischen dem Kopf jeder Schraube und der jeweiligen Platte (24A, 24B) befinden, wobei sich eines der Enden jeder Feder auf der jeweiligen Platte (24A, 24B) abstützt.

6. Vorrichtung nach einem der Ansprüche 3 bis 5, **dadurch gekennzeichnet, dass** auf jeder Seite der Leiterplatte (2) jede Säule (16, 17, 18, 19) mit einer Feder mit demselben Steifigkeitskoeffizienten ausgestattet ist, um einen gleichmäßigen Druck auszuüben, der imstande ist, den elektrischen Kontakt zwischen jedem integrierten Schaltkreis (4A, 4B) und der Leiterplatte (2) herzustellen.

7. Verfahren zur Montage einer Vorrichtung (1) nach einem der Ansprüche 1 bis 6, **dadurch gekennzeichnet, dass** es aufweist: die Verwendung eines Werkzeugs, das Mittel zur Ausübung eines Drucks auf einen ersten integrierten Schaltkreis (4A), die auf einer ersten Fläche der Leiterplatte befestigt ist, derart umfasst, dass ein zweiter integrierter Schaltkreis (4B) auf der Fläche gegenüber der Leiterplatte (2) montiert wird.

## Claims

1. Device (1) including:
- a printed circuit card (2) comprising connection pads on both of its opposite sides and traversed by openings (11, 12, 13, 14),
- two assemblies, each comprising:
• an integrated circuit (4A, 4B) having an electrically active side and an electrically non active side,
• a heat sink (5A, 5B) in thermal contact with the electrically non active side of the integrated circuit (4A, 4B), and
• a plate (24A, 24B) with holes, placed between the integrated circuit (4A, 4B) and the heat sink (5A, 5B),
- fastening means (16, 17, 18, 19) with springs (25A, 25B, 26A, 26B, 27A, 27B, 28A, 28B), inserted in the openings (11, 12, 13, 14) of the printed circuit card (2) and in the holes of each plate (24A, 24B), which extend through the printed circuit card (2) and through each plate (24A, 24B), fastening both of the assemblies respectively on both of the opposite sides of the printed circuit card (2) for establishing an electrical contact between the electrically active side of the integrated circuit (4A, 4B) of each assembly and the side of the printed circuit card (2) on which said assembly is fastened,
**characterized in that**:
- the springs (25A, 25B, 26A, 26B, 27A, 27B, 28A, 28B) of the fastening means (16, 17, 18, 19) put weight against the plates (24A, 24B) by applying a pressure force for securing said electrical contact, and
- each assembly further comprises a twist clip (34A, 34B) which connects its heat sink (5A, 5B) with its plate (24A, 24B) so as to exert, on this heat sink - plate set (5A-24A, 5B-24B), a pressure force independent of the pressure force produced by the springs.

2. Device according to claim 1, **characterized in that** the springs (25A, 25B, 26A, 26B, 27A, 27B, 28A, 28B) of the fastening means (16, 17, 18, 19) exert equal pressures on both sides of the printed circuit card (2).

3. Device according to claim 1 or 2, **characterized in that** the fastening means (16, 17, 18, 19) are standoffs, each standoff comprising on both of its ends a threaded part that receives a screw for attaching the integrated circuits (4A, 4B).

4. Device according to claim 3, **characterized in that** the shapes of the holes of the plates (24A, 24B) and of the standoffs (16, 17, 18, 19) prevent any rotational movement of the standoffs (16, 17, 18, 19) for mounting or removal.

5. Device according to claim 3 or 4, **characterized in that** the springs (25A, 25B, 26A, 26B, 27A, 27B, 28A, 28B) are inserted between the head of each screw and the respective plate (24A, 24B), one of the ends of each spring pressing against the respective plate (24A, 24B).

6. Device according to any one of claims 3 to 5, **characterized in that**, on each side of the printed circuit card (2), each standoff (16, 17, 18, 19) is equipped with a spring having the same stiffness coefficient in order to exert a uniform pressure capable of establishing the electrical contact between each integrated circuit (4A, 4B) and the printed circuit card (2).

7. Method for mounting a device (1) according to any one of claims 1 to 6, **characterized in that** it comprises: using a tool which includes means for exerting a pressure on a first integrated circuit (4A) fastened on a first side of the printed circuit card, so as to mount a second integrated circuit (4B) on the opposite side of the printed circuit card (2).
